# EUROPEAN PATENT APPLICATION

(11) **EP 4 716 450 A1**
(43) Date of publication of application: **25.03.2026**
(21) Application number: 25197544.7
(22) Date of filing: 22.08.2025
(51) Int. Cl.: H10W 70/68, H10W 70/685, H10W 70/692, H10W 70/63

(54) **IC PACKAGES WITH SUBSTRATES HAVING GLASS CORES WITH LARGE FOOTPRINTS, THIN REDISTRIBUTION LAYERS, AND ELECTRICAL COMPONENTS**

(30) Priority: 24.09.2024 US 202418894749
(71) Applicant: Intel Corporation, Santa Clara, CA 95054 (US)
(72) Inventor: DUAN, Gang, Chandler, 85248 (US); PIETAMBARAM, Srinivas, Chandler, 95249 (US); ECTON, Jeremy, Gilbert, 85298 (US); MARIN, Brandon, Gilbert, 85234 (US); KANAOKA, Yosuke, Chandler, 85249 (US); NAD, Suddhasattwa, Chandler, 85286 (US); MANEPALLI, Rahul, Chandler, 85249 (US)
(74) Representative: HGF

(57) **Abstract**

An apparatus comprises a first IC die over a substrate comprising a glass core. The glass core comprises a first surface and a second surface opposite the first surface. The first surface comprises an area of at least 5,000 mm². A redistribution layer is on the first surface. The redistribution layer comprises a thickness of 100 µm or less. An electrical component is within a region of the glass core between the first and second surfaces. A through-glass via extends between the first and second surfaces. A second IC die is over and directly bonded to the first IC die.

## Description

### BACKGROUND

In electronics manufacturing, integrated circuit (IC) packaging is a stage of semiconductor device fabrication in which an IC that has been monolithically fabricated on a chip (or die) is assembled into a "package" that can protect the IC chip from physical damage. The package connects the IC chip to other packaged IC chips and/or a scaled host component, such as a package substrate, or a printed circuit board. Multiple IC chips can be assembled into a multi-die package.

In traditional methods, IC chips may be placed side by side on a substrate. To obtain tighter integration than is possible using traditional methods, IC chips may be stacked on top of each other using three-dimensional (3D) packaging techniques. In a heterogenous architecture, different types of IC chips, that may be manufactured using different processes, may be integrated into a single IC package. A heterogeneous 3D IC package can require a larger form factor than a traditional IC package.

Traditionally, package substrates were made from organic materials. More recently, package substrates with a glass core between layers of organic materials have been introduced. A substrate with a glass core may be used to accommodate the larger form factors of heterogeneous 3D IC packages. A glass core substrate may be stronger, flatter, and more dimensionally stable than a traditional organic substrate.

One challenge with glass core substrates is SeWaRe defects. These defects may be formed at edges of the glass after a wafer is cut into individual package substrates. SeWaRe defects are small cracks in the glass at the cut edge. These cracks may propagate inward from the edge during subsequent processing and handling. SeWaRe defects can significantly reduce manufacturing yield.

### BRIEF DESCRIPTION OF THE DRAWINGS

The subject matter described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Views referred to as "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure. Further, where considered appropriate, reference labels have been repeated among the figures to indicate corresponding or analogous elements. In the figures:
FIG. 1 illustrates a flow diagram of methods for forming an IC device package including a glass-core substrate having a relatively large footprint, relatively thin redistribution layers, an electrical component within the glass core, and one or more IC die over the substrate, in accordance with some embodiments;
FIG. 2 is a cross-sectional view of a glass panel received at an initial stage of fabrication, in accordance with some embodiments;
FIGS. 3A and 3B are cross-sectional views of a glass panel at a stage of fabrication after alternative features have been formed in the glass panel, in accordance with some embodiments;
FIG. 3C is a plan view of a glass panel at a stage of fabrication after various features have been formed in the glass panel, in accordance with some embodiments;
FIGS. 4A, 4B, and 4C are cross-sectional views of a glass panel at a stage of fabrication after an electrical component has been placed in a region within the glass panel and through-glass vias (TGVs) have been formed, in accordance with some embodiments;
FIG. 5 is a cross-sectional view of a glass core substrate at a stage of fabrication after a redistribution layer and interconnect features have been formed on a surface of the glass core substrate, in accordance with some embodiments;
FIG. 6 is a cross-sectional view of a glass core substrate at a stage of fabrication after first IC dies have been attached to a surface of the glass core substrate, in accordance with some embodiments;
FIG. 7 is a cross-sectional view of a glass core substrate at a stage of fabrication after first IC dies have been attached to a surface of the glass core substrate and second IC dies have been attached to the first IC dies, in accordance with some embodiments;
FIG. 8 illustrates a system including one of the IC packages illustrated in FIG. 7 attached to a host component with FLI features, in accordance with some embodiments;
FIG. 9 illustrates a mobile computing platform and a data server machine employing one or more apparatus comprising an IC package with a substrate having a glass core with a large footprint, one or more thin redistribution layers, and one or more electrical components, in accordance with some embodiments; and
FIG. 10 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

**As** used in the description and the appended claims, the singular forms "a", "an" and "the" are intended to include the plural forms as well, unless the context clearly indicates otherwise. It will also be understood that the term "and/or" as used herein refers to and encompasses all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, Band C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1 % of any constituent substituted for either the first or second constituent.

One challenge with glass core substrates are small cracks in the glass at cut edges, such as SeWaRe defects. SeWaRe defects can significantly reduce manufacturing yield. The susceptibility of a glass core to SeWaRe defects may increase with the thickness of build-up layers of metallization and dielectric formed on surfaces of the glass. As the number of individual metallization and dielectric layers in a redistribution layer increase, the stress on the glass core may increase. Similarly, as the thickness of individual metallization and dielectric layers in a redistribution layer increase, the stress on the glass core may increase. An advantage of the embodiments described herein is that stresses on the glass core may be reduced, leading to fewer SeWaRe defects and improved manufacturing yield.

Another advantage of embodiments described herein is that package substrates with a glass core are more rigid and can accommodate more IC dies than substrates made from organic materials. Further advantages of embodiments described herein is that voltage regulation (VR) circuitry may be integrated into an IC package and IC dies may be stacked using hybrid bonding thereby providing IC packages having a small form factor.

Embodiments disclosed herein are directed to IC packages with glass core substrates with a redistribution layer (RDL) on at least one surface of the glass core. A redistribution layer includes one or more metal layers. Each of the metal layers includes conductive metal lines, e.g., copper traces. Within a metal layer, dielectric material separates the conductive metal lines. In addition, a dielectric layer is over each metal layer within the RDL. The metal lines may be used to route electrical signals from contacts or features on a surface of the package substrate to other points on the surface or to other points in the package substrate. For example, the metal lines may be used to route electrical signals from conductive features on a front surface to other conductive features on the front or back surface, or to an electrical component within the package substrate.

As used herein, redistribution layer or RDL may refer to an individual metal layer or layers. RDL may also refer to the combined metal and adjacent dielectric layers, where the context indicates the intended meaning. For example, in some embodiments, an RDL (individual metal layer) may have a thickness of less than 10µm. In some examples, a dielectric layer over a metal layer may have a thickness of 10-35 µm. In other examples, a dielectric layer over a metal layer may have a thickness of 10-20 µm. In one example, an RDL comprising a thickness of 100 µm or less may have ten (10) metal layers having a thickness of less than 5 µm, and (10) adjacent dielectric layers having a thickness of less than 5 µm. In another example, an RDL comprising a thickness of 100 µm or less may have twelve (12) metal layers having a thickness of less than 4 µm, and (12) adjacent dielectric layers having a thickness of less than 4 µm.

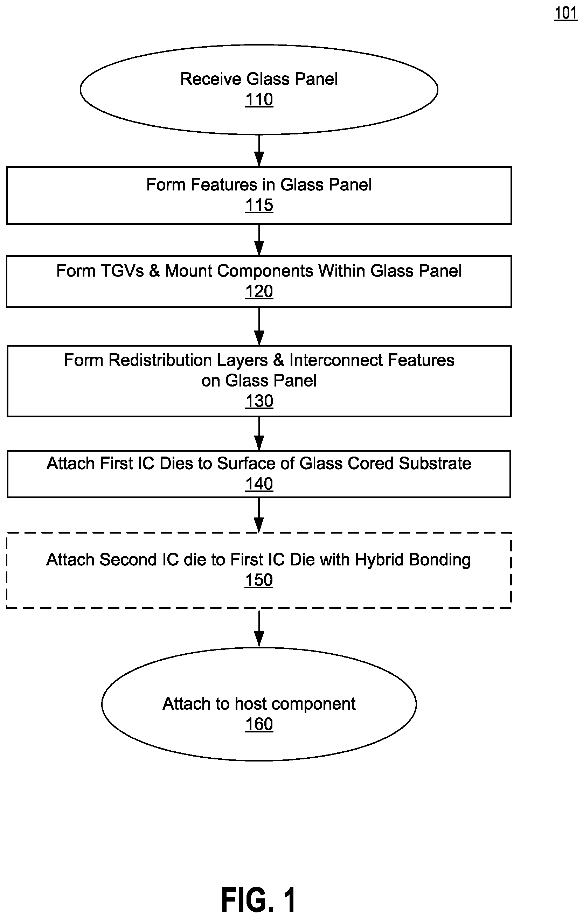

As illustrated in **FIG. 1****,** a variety of fabrication methods may be practiced to form IC device package structures having one or more of the features described herein. FIG. 1 illustrates a flow diagram of methods for forming an IC device package including a glass-core substrate having a relatively large footprint, relatively thin redistribution layers, an electrical component within the glass core, and one or more IC die over the substrate, in accordance with some embodiments. Methods 101 begin at input 110 where a workpiece including a thickness of glass is received. The workpiece may be prepared upstream of methods 101 and may be in a large panel format, a wafer format, or the like. The workpiece received at input 110 may be patterned with a plurality of holes, as described below, or the workpiece may not be patterned, e.g., holes may be absent from the workpiece. The holes may be of a variety and shapes and size, and may alternatively be referred to as "openings" herein.

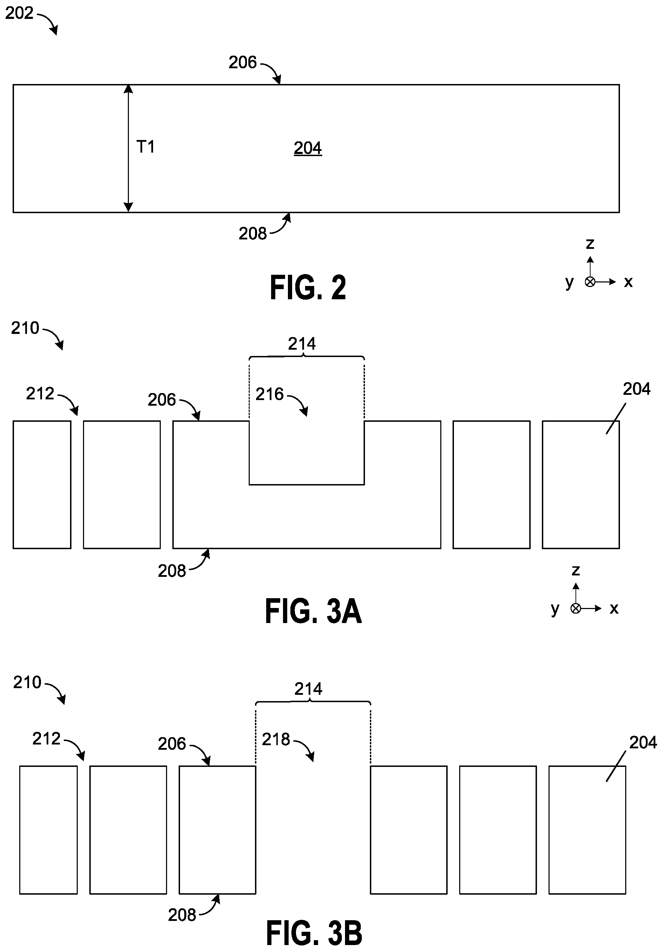

**FIG. 2** is a cross-sectional view of a glass panel 204 received at an initial stage of fabrication 202, in accordance with some embodiments. Advantages of fabricating IC device package structures upon such a glass are that the flatness and/or thickness control for a preform of glass is superior to that of starting substrates based on organic materials (e.g., epoxy), and the costs can be significantly lower than for monocrystalline materials (e.g., silicon). Glass 204 is a solid bulk material layer that may have been previously formed into any shape suitable for a packaging workpiece, such as rectangular. Glass 204 includes a first surface 206 and a second surface 208 opposite the first surface. Glass 204 has a thickness T1 that may vary with implementation, for example to limit warpage while remaining thin enough to permit the formation of through vias at a pitch as small as is enabled by the surface flatness of glass 204. In exemplary embodiments, thickness T1 is advantageously 0.2 mm to 1.6 mm.

Although not depicted, one or more material layers may clad either or both of the first surface 206 or second surface 208 of glass 204 so that glass 204 is a bulk or core layer of a multilayered substrate. Exemplary cladding materials include inorganic materials such as silicon nitride (SiNx) or silicon oxynitride (SiOxNy). In other embodiments, a silicon layer (polycrystalline or monocrystalline) may clad one or both sides of glass 204. Organic material layers, such as polymer dielectric materials, may also clad one or more sides of glass 204. Hence, while glass 204 is advantageously substantially free of organic materials (e.g., no adhesives, etc.), a workpiece at stage 202 may include organic material within a substrate stack that includes glass 204.

Glass 204 is advantageously predominantly silicon and oxygen. In some embodiments, glass 204 comprises at least 23 percent silicon and at least 26 percent oxygen, by weight (i.e., wt. %). Glass 204 may further include one or more additives, such as, Aluminum, Boron, Magnesium, Calcium, Barium, Tin, Sodium, Potassium, Strontium, Phosphorus, Zirconium, Lithium, Titanium, or Zinc. In some embodiments where glass 204 comprises at least 23 wt. % Si and at least 26 wt. % O, glass 204 further comprises at least 5 wt. % Al. Additives within glass 204 may form suboxides (A2O) monoxides (AO), binary oxides (AO2), ternary oxides (ABO3), and mixtures thereof. For example, glass 204 may comprise AlOx (e.g., Al2O3), BOx (e.g., B2O3), MgOx (e.g., MgO), CaOx (e.g., CaO), SrOx (e.g., SrO), BaOx (e.g., BaO), SnOx (e.g., SnO2), NaOx (e.g., Na2O), KOx (e.g., K2O), POx(e.g., P2O3), ZrOx (e.g., ZrO2), LiOx (e.g., Li2O), TiOx (e.g., TiO2), or ZnOx (e.g., ZnO2). Depending on chemical composition, glass 204 may therefore be referred to as silica, fused silica, aluminosilicate, borosilicate, or alumino-borosilicate, for example.

Glass 204 is advantageously a bulk material of substantially homogeneous composition in contrast to a composite material that may merely comprise glass fillers and/or fibers. Although glass 204 is substantially amorphous in some embodiments, glass 204 may also have other morphology or microstructure, such as polycrystalline (e.g., nanocrystalline).

Returning to FIG. 1, methods 101 continue at block 115 where features are formed in unpatterned glass 204. The features may be fabricated with any process known to be suitable for bulk glass. In some embodiments, block 115 entails laser ablation, a glass etch process (laser-assisted, or otherwise), or any other technique known to be suitable for forming features through a thickness of glass at a desired diameter and feature pitch. Example features include holes and openings.

**FIGS. 3A and 3B** are cross-sectional views of glass panel 204 at a stage of fabrication 210 after alternative features have been formed in the glass panel, in accordance with some embodiments. The features may include through holes 212 that extend through thickness T1 between the first and second surfaces 206, 208. In a subsequent operation, through-glass vias will be formed in through holes 212. As illustrated in FIG. 3A, the features may include an opening 216, which is a blind hole or recess that does not pass entirely through thickness T1. While opening 216 is at first surface 206 in the illustrated example, in other examples, opening 216 may be at second surface 208. The features may also include an opening 218, as illustrated in FIG. 3B, which is a through hole that extends through thickness T1 between the first and second surfaces 206, 208. In a subsequent operation, openings 216, 218 will receive an electrical component. The openings 216, 218 are formed in regions 214 of the glass panel 204. A region 214 extends in the x-y plane and vertically in the z-direction through thickness T1.

The examples shown in **FIGS. 3A and 3B** are indicative of a substantially single-sided symmetrical hole formation process resulting in through holes 212 and openings 216, 218 in a region 214 of the glass panel 204. While the holes and openings are shown with straight sidewalls, in other examples, the through holes and opening are asymmetric about a longitudinal z-axis with tapered x-dimension lateral widths that are largest at first surface 206 and smallest at second surface 208. The dimensions of through holes 212 and openings 216, 218 may vary with implementation. The dimensions of openings 216, 218 may be at least marginally larger than the dimensions of an electrical component that will be placed within the opening.

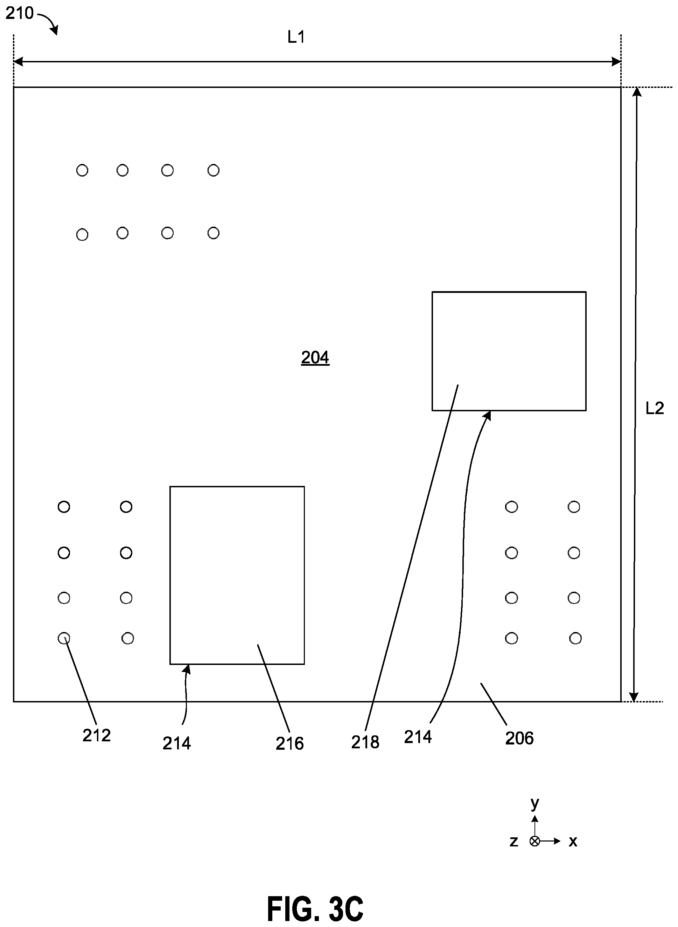

**FIG. 3C** is a plan view of a glass panel 204 at a stage of fabrication 210 after various features have been formed in the glass panel, in accordance with some embodiments. Through holes 212 may have any shape within a plan view (x-y) plane, such as substantially circular, rectangular, or any other polygon. Similarly, openings 216, 218 may have any shape within a plan view plane, e.g., rectangular or square. Openings 216, 218 may take a shape suitable to accommodate a desired electrical component.

Glass panel 204 includes sides that have lengths L1 and L2. Glass panel 204 may be used in glass core substrate that has a larger form factor than a traditional IC package. In some examples, an IC package with a glass panel 204 at its core has an ultra large form factor (ULFF). Accordingly, glass panel 204 has a relatively large footprint, i.e., the surface area defined by L1 and L2. In some embodiments, a surface of a glass panel has a footprint or area of at least 5,000 mm². For example, side lengths L1 and L2 may each be 75 mm so that the footprint or area of the glass panel is 5,625 mm². Side lengths L1 and L2 need not be equal. For example, L1 may be 60 mm and L1 may be 95 mm, giving a glass panel foot print or area of 5,625 mm². In some embodiments, a surface of a glass panel has a footprint or area of at least 6,000 mm². For example, side lengths L1 and L2 may each be 80 mm so that the footprint or area of the glass panel is 6,400 mm².

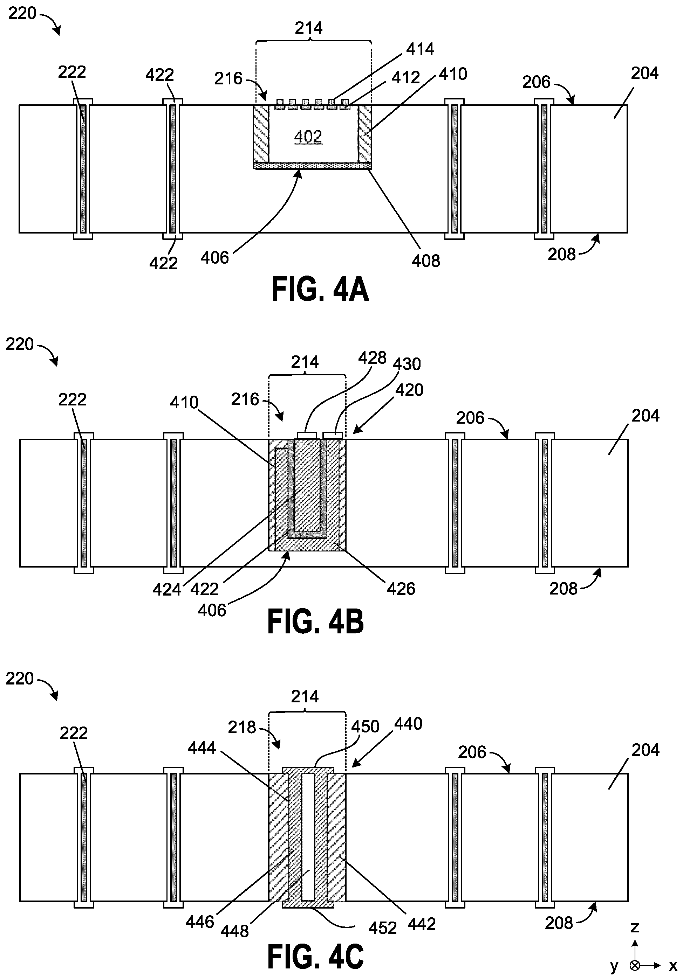

Returning to FIG. 1, methods 101 continue at block 120 where TGVs are formed and one or more electrical components are placed within an opening in a region of a glass panel, in accordance with some embodiments. **FIGS. 4A, 4B, and 4C** are cross-sectional views of glass panel 204 at a stage of fabrication 220 after TGVs have been formed and different electrical components have been placed in region 214 within the glass panel 204, in accordance with some embodiments. The TGVs 222 may include any metallization suitable as a conductive path through substrate thickness T1. In some examples TGVs 222 are at least partially filled with copper. TGVs 222 include conductive features 422 on first and second surfaces 206, 208. Any suitable electrical component may be placed in region 214 within glass panel 204, e.g., an IC die or an electrical circuit device, such as a capacitor or an inductor.

**FIG. 4A** illustrates glass panel 204 after an electrical component 402 has been placed in region 214 in opening 216. Because opening 216 does not pass entirely through thickness T1, it includes a recessed surface 406 substantially parallel to first surface 206. Electrical component 402 may be mechanically coupled to glass panel 204 by adhesive layer 408 on recessed surface 406. An underfill material 410 may be formed around electrical component 402. Example materials for underfill material 410 include dielectric, epoxy materials that may be applied in a capillary process. Electrical component 402 includes conductive features 412 proximate a surface and conductive features 414 on a surface, e.g., first surface 206. While FIG. 4A illustrates electrical component 402 in a blind hole type opening, in other embodiments, an electrical component may be placed in a through hole type opening. In one example, an electrical component may be placed in a through hole in a process in which glass panel is mounted on a sacrificial panel. In addition, while FIG. 4A illustrates conductive features 412, 414 on or proximate first surface 206, in other examples, conductive features 412, 414 may be at second surface 208 or at both surfaces 206, 208.

In some examples, the electrical component 402 is an IC die. For example, electrical component 402 may be an integrated voltage regulator (IVR) IC die. In other examples, electrical component 402 may be an IC die having circuitry for performing any desired function, e.g., input/output interfacing, security, memory, etc. In some embodiments, electrical component 402 is an optical or photonic IC. In yet other examples, electrical component 402 is an IC die that includes active or passive bridge circuitry. For example, electrical component 402 may be a low-cost interconnected bridge (LSI) IC die. In some embodiments, the electrical component 402 is a discrete capacitor or a discrete inductor.

In various embodiments, instead of placing an electrical component in an opening in region 214, the electrical component is formed (or embedded) in an opening in region 214. For example, the electrical component may be an embedded capacitor or an embedded inductor.

**FIG. 4B** illustrates glass panel 204 after a capacitor 420 has been formed in opening 216 in region 214. Capacitor 420 includes a dielectric layer 422 between a first electrode 424 and a second electrode 426. Any suitable metal may be used for electrodes 424, 426. Capacitor 420 includes conductive features 428, 430 at a surface of the glass panel 204. In the illustrated example, the second electrode 426 is formed on surface 406 and underfill material 410 is placed around capacitor 420. Any type or design of capacitor may be placed in region 214. Examples of capacitors that may be placed in region 214 include core trench capacitors (CTC) and embedded deep trench capacitors (eDTCs). In some examples, a capacitor may be in a through hole, e.g., opening 218, in region 214. In various embodiments, conductive features 428, 430 may be at second surface 208 or at both surfaces 206, 208.

**FIG. 4C** illustrates glass panel 204 after an inductor 440 has been formed in opening 216 in region 214. Embedded inductor 440 is a coaxial metal loop type inductor. Inductor 440 includes a magnetic material 442 surrounding a plated hole 444. The plated hole 444 includes an outer wall 446 of conductive material, e.g., metal, that may be fabricated using a plating process. Within the outer wall 446, the plated hole 444 contains an inner core 448 of insulating material, e.g., a dielectric material, that may be fabricated using a deposition process. In various embodiments, the conductive material of outer wall 446 may be copper or another suitable metal. The insulating or dielectric material of inner core 448 may be an organic material, such as epoxy. The magnetic material 442 may be any suitable material with magnetic properties. In some examples, magnetic material 442 is a dielectric material or an organic material comprising a ferromagnetic material, a ferrimagnetic material, or a Heusler alloy. Embedded inductor 440 includes conductive features 450, 452 at a surface of the glass panel 204. In cross-section in the y-x plane, embedded inductor 440 may have a generally cylindrical (or oval) shape, or a rectangular shape. Any suitable type or design of inductor may be embedded in region 214. For example, an embedded inductor in region 214 be an inductor with an air core.

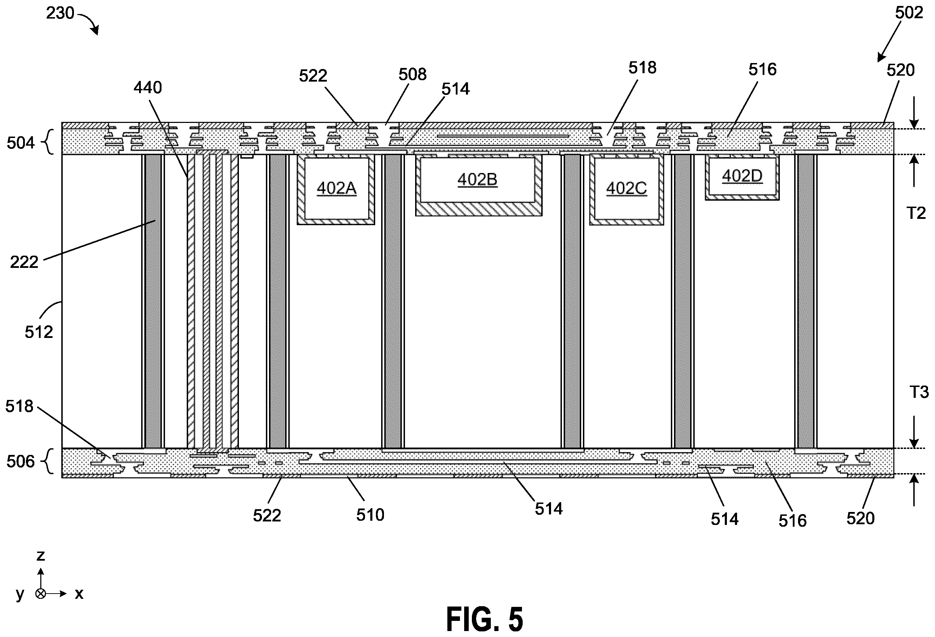

Returning to FIG. 1, methods 101 continue at block 130 where redistribution layers (RDLs) and interconnect features are formed on a glass panel, in accordance with some embodiments. **FIG. 5** is a cross-sectional view of a glass core substrate 502 at a stage of fabrication 230 after redistribution layers 504, 506 and interconnect features 508, 510 have been formed on a surface of the glass core substrate 502, in accordance with some embodiments.

The glass core substrate 502 illustrated in FIG. 5 includes a glass core 512 that may be the same as or similar to the glass panel 204 described above. Glass core 512 may have the same of similar composition, thickness T1, and footprint of glass panel 204. In some examples, glass core substrate 502 includes one or more TGVs 222 extending between the first and second surfaces of glass core 512, and one or more electrical components 402 within a region of the glass core 512 between the first and second surfaces. In the illustrated example, five electrical components 402A, 402B, 402C, 402D, and 440 are depicted. Each of the electrical components 402A, 402B, 402C, and 402D may be a different type of component. For example, any of the electrical components 402A, 402B, 402C, and 402D may be an IC die comprising active or passive bridge circuitry, or voltage regulation circuitry. Further, any of the electrical components 402 may be a discrete capacitor or a discrete inductor. In the example illustrated in FIG. 5, an embedded inductor 440 has been formed within a region of the glass core 512. Embedded inductor 440 extends between the first and second surfaces glass core 512. In other embodiments, an embedded capacitor may be provided, such as the one shown in FIG. 4B.

As illustrated in FIG. 5, a first RDL 504 has been formed on a first surface of glass core 512 and a second RDL 506 has been formed on a second surface of the glass core 512 opposite the first surface. In some examples, an RDL may be formed on only one of the two surfaces. Each of first and second RDLs 504, 506 includes one or more metal (or metallization) layers and one or more dielectric layers. A dielectric layer comprising an organic dielectric material 516, such as Ajinomoto^{®} Build-up Film (ABF), polyimide, or other suitable material is provided over each metallization layer within the RDL. Each of the metallization layers includes metal features, such as conductive traces or interconnect lines 514, e.g., copper traces. Metal features within an RDL also include conductive vias 518.

In the example illustrated in FIG. 5, outer layers 520 (e.g., the top-most or bottom-most layer) of glass core substrate 502 have been formed on RDLs 504, 506. The outer layers 520 may include an organic dielectric material that is different from the dielectric layers of the RDLs. For example, the dielectric material in the outer layer may be a solder resist material 522. As depicted in FIG. 5, interconnect features (or contact pads) 508, 510 have been formed within the outer layers 520 at top and bottom surfaces of the glass core substrate 502. Interconnect features 508, 510 may be flush with the top and bottom surfaces and separated by the solder resist material 522.

In some examples, the interconnect lines 514 have a pitch of 5 µm or less. Interconnect line size and spacing, along with pad size, may be designed so that source and load impedances match, which facilitates high speed signaling. Within a metallization layer, dielectric material 516 may separate interconnect lines 514. Conductive vias 518 extend through a dielectric layer to connect interconnect lines 514 and metal features in different metal layers. The interconnect lines 514 may be used to route electrical signals from contacts or features on a surface of the glass core substrate to other points on the surface or to other points in the substrate. For example, the interconnect lines 514 may be used to route electrical signals from conductive features on a front surface to other conductive features on the front or back surface, or to and from an electrical component within the substrate.

As depicted in FIG. 5, first RDL 504 has a thickness T2 and second RDL 506 has thickness T3. As used herein, a thickness of a redistribution layer (RDL) may refer to the combined thickness of the metallization and adjacent dielectric layers, e.g., thicknesses T2, T3. In various embodiments, an RDL has a thickness of 100 µm or less. For example, RDL 504 comprises a thickness T2 of 100 µm or less, and RDL 506 comprises a thickness T3 of 100 µm or less. In various embodiments, an individual metallization layer within an RDL has a thickness of less than 10µm, and a dielectric layer over an individual metallization layer may have a thickness of 10-20µm. In one example, RDL 504 includes five (5) metallization layers, each having a thickness of 7 µm, and five (5) adjacent dielectric layers each having a thickness of 12 µm for a combined thickness T2 of 95 µm. In various embodiments, an RDL has 12 or fewer metallization layers. For example, an RDL may have 10 metallization layers.

In some examples, at least one of the TGVs 222 extending between the first and second surfaces of glass core 512 contacts both a first metal feature in RDL 504 and a second metal feature in RDL 506. Example first and second metal features include interconnect lines 514 or conductive surfaces contacting an interconnect line 514.

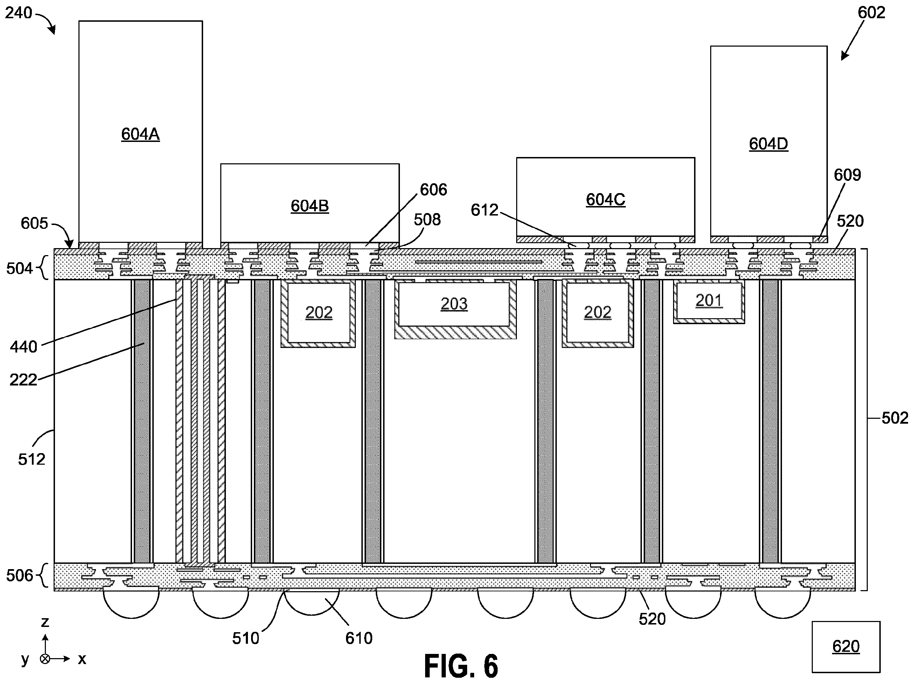

Returning to FIG. 1, methods 101 continue at block 140 where first IC dies are attached to a glass core substrate, in accordance with some embodiments. **FIG. 6** is a cross-sectional view of a glass core substrate at a stage of fabrication 240 after first IC dies have been attached to a surface of the glass core substrate, in accordance with some embodiments.

**FIG. 6** illustrates glass core substrate 502 after IC dies 604A, 604B, 604C, and 604D have been attached to a surface, e.g., a front surface 605, of the glass core substrate 502. The assembly depicted in FIG. 6 may be referred to as an IC package 602. Each of IC dies 604A, 604B, 604C, and 604D include conductive features (or pads) 606 at a respective surface of an IC die facing front surface 605. Conductive features 606 are disposed in a layer 609, which may comprise a dielectric material or a solder resist material. Conductive features 606 are coupled with interconnect features 508. In some embodiments, conductive features 606 are coupled with interconnect features 508 by solder features 612. In some embodiments, conductive features 606 are directly bonded to interconnect features 508 using a hybrid bonding technique. When hybrid bonding is employed, surface metal features embedded within an insulator of one IC die are directly fused to surface metal features embedded within an insulator of another die (or in this case within an RDL). The hybrid bonded interface between the dies may include both metallurgically interdiffused metals and chemically bonded insulators. In the example illustrated in FIG. 6, first level interconnects (FLI) have been formed on exposed surfaces of interconnect features 510 in preparation for packaging or assembly. In various embodiments, solder features 610 are formed as the FLI.

The IC dies 604A, 604B, 604C, and 604D may comprise circuitry to perform any desired functionality. For example, any of IC dies 604A, 604B, 604C, and 604D may be a logic circuit, a power management integrated circuit, a transmitter, a receiver, a memory controller, a communications controller, a controller, a processor, an application specific integrated circuit (ASIC), or a memory. Any of any of IC dies 604A, 604B, 604C, and 604D may be a photonic integrated circuit (PIC) or include optical or photonic elements. IC package 602 may include a power supply 620, which may be coupled with glass core substrate 502. Power may be provided to IC dies 604A, 604B, 604C, and 604D from power supply 620 by conductive structures within glass core substrate 502, e.g., RDLs 504, 506, and TGVs 222.

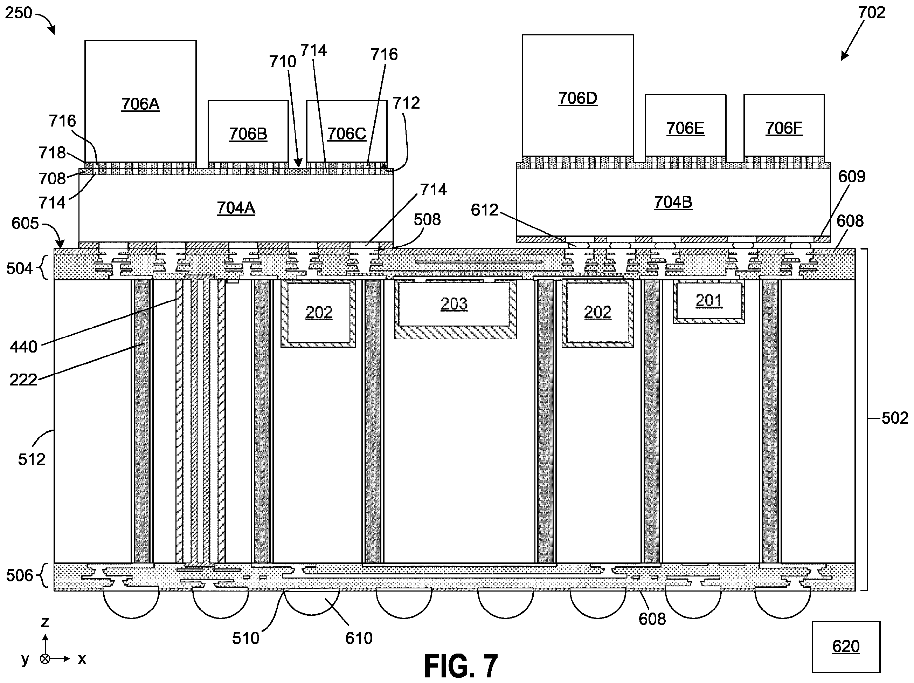

Returning to FIG. 1, methods 101 continue at block 150 where one or more second IC dies are attached to a first IC die using a hybrid bonding technique, wherein the first IC die was previously attached to a glass core substrate, in accordance with some embodiments. Block 150 is shown in a dashed line as the operations at block 150 are optional. **FIG. 7** is a cross-sectional view of a glass core substrate at a stage of fabrication 250 after first IC dies 704 have been attached to a surface of glass core substrate 502 and second IC dies 706 have been attached to the first IC dies 704 using a hybrid bonding technique, in accordance with some embodiments.

As illustrated in FIG. 7, IC die 704A and IC die 704B have been attached to front surface 605 of the glass core substrate 502. The assembly depicted in FIG. 7 may be referred to as an IC package 702. Each of IC dies 704A, 704B include conductive features (or pads) 714 at a respective surface of the IC die facing front surface 605. Conductive features 714 are disposed in a layer 609, which may comprise a dielectric material or a solder resist material. Conductive features 714 are coupled with interconnect features 508. In some embodiments, conductive features 714 are coupled with interconnect features 508 by solder features 612. In some embodiments, conductive features 714 are directly bonded to interconnect features 508 using a hybrid bonding technique.

Each of IC dies 704A, 704B include an upper surface 710 that is opposite the surface of the IC die facing front surface 605. IC dies 704A, 704B have metal features 714, e.g., contacts or pads, at upper surface 710. Metal features 714 may be flush with upper surface 710 and separated by a dielectric material 708.

Each of IC dies 706A, 706B, 706C, 706D, 706E, and 706F include a surface 712 that faces upper surface 710 of an IC die 704. Each of IC dies 706A, 706B, 706C, 706D, 706E, and 706F include metal features 716, e.g., contacts or pads, at surface 712. Metal features 716 may be flush with surface 712 and separated by a dielectric material 718.

In some embodiments, IC die 704A and one of more of IC die 706A, 706B, and 706C are electrically and mechanically coupled to one another using a hybrid bonding technique. Similarly, IC die 704B and one of more of IC die 706D, 706E, and 706F may be electrically and mechanically coupled to one another using a hybrid bonding technique. As one example, with reference to IC die 704A and 706C, the interface between surfaces 710 and 712 may be a hybrid bonded interface and the respective metal features 714, 716 on surfaces 710, 712 are hybrid bonded interconnects.

Any of the IC dies 704A, 704B, and any of the IC dies 706A, 706B, 706C, 706D, 706E, and 706F may comprise circuitry to perform any desired functionality. In some examples, any of the IC dies 704A, 704B, and any of the IC dies 706A, 706B, 706C, 706D, and 706E may comprise memory circuitry or logic circuitry. In other examples, any of the IC dies 704A, 704B, and any of the IC dies 706A, 706B, 706C, 706D, and 706E may be a logic circuit, a power management integrated circuit, a transmitter, a receiver, a memory controller, a communications controller, a controller, a processor, an application specific integrated circuit (ASIC), or a memory. In further examples any of the IC dies 704A, 704B, and any of the IC dies 706A, 706B, 706C, 706D, and 706E may be a photonic integrated circuit (PIC) or include optical or photonic elements. IC package 702 may include a power supply 620, which may be coupled with glass core substrate 502. Power may be provided to any of the IC dies 704A, 704B, and any of the IC dies 706A, 706B, 706C, 706D, and 706E from power supply 620 by conductive structures within glass core substrate 502, e.g., RDLs 504, 506, and TGVs 222.

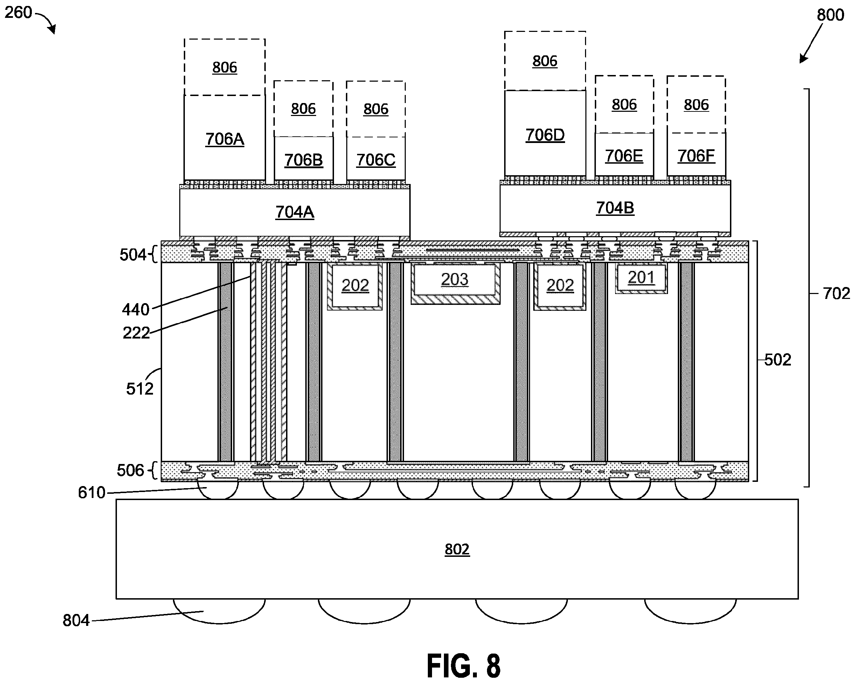

Returning to FIG. 1, methods 101 continue at block 160 where one of the IC packages described herein is attached to a host component, in accordance with some embodiments. **FIG. 8** illustrates a system 800 including IC package 702 at a stage of fabrication 260 after IC package 702 has been attached to a host component 802 by reflowing FLI interconnects (solder features 610). In other examples, IC package 602 may be attached to host component 802. In embodiments, FLI interconnects 610 are solder (e.g., SAC) microbumps although other interconnect features are also possible. Host component 802 may also comprise one or more materials known to be suitable as interposers or package substrates (e.g., an epoxy preform, cored or coreless laminate board, etc.). Host component 802 may include one or more metallized redistribution levels (not depicted) embedded within a dielectric material. Host component 802 may also include one or more IC die embedded therein.

Host component 802 may further include second level interconnects (SLI) 804. SLI 804 may comprise any solder (ball, bump, etc.) suitable for a given host board architecture (e.g., surface mount FR4, etc.). As illustrated in dashed line, one or more heat spreaders and/or heat sinks 806 may be further coupled to system 800, which may be advantageous, for example, where IC dies 704, 706 comprise one or more CPU cores or other circuitry of similar power density.

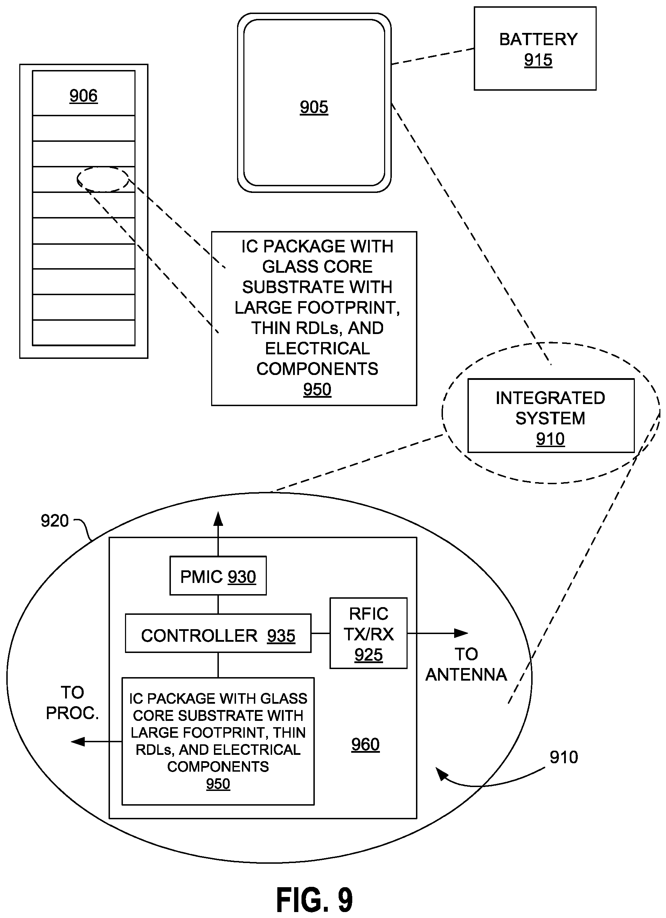

**FIG. 9** illustrates a mobile computing platform and a data server machine employing one or more apparatus comprising an IC package 950 with a substrate having a glass core with a large footprint, one or more thin redistribution layers, and one or more electrical components, for example as described elsewhere herein. Server machine 906 may be any commercial server, for example including any number of high-performance computing platforms disposed within a rack and networked together for electronic data processing. The mobile computing platform 905 may be any portable device configured for each of electronic data display, electronic data processing, wireless electronic data transmission, or the like. For example, the mobile computing platform 905 may be any of a tablet, a smart phone, laptop computer, etc., and may include a display screen (e.g., a capacitive, inductive, resistive, or optical touchscreen), a chip-level or package-level integrated system 910, and a battery 915.

Whether disposed within the integrated system 910 illustrated in the expanded view 920, or as a stand-alone package within the server machine 906, the IC package 950 with a substrate having a glass core with a large footprint, one or more thin redistribution layers, and one or more electrical components, as described elsewhere herein. IC package 950 may be further coupled to a host substrate 960, along with, one or more of a power management integrated circuit (PMIC) 930, RF (wireless) integrated circuit (RFIC) 925 including a wideband RF (wireless) transmitter and/or receiver (TX/RX) (e.g., including a digital baseband and an analog front-end module further comprises a power amplifier on a transmit path and a low noise amplifier on a receive path), and a controller 935. PMIC 930 may perform battery power regulation, DC-to-DC conversion, etc., and so has an input coupled to battery 915 and with an output providing a current supply to other functional modules. As further illustrated, in the exemplary embodiment, RFIC 925 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 4G, and beyond.

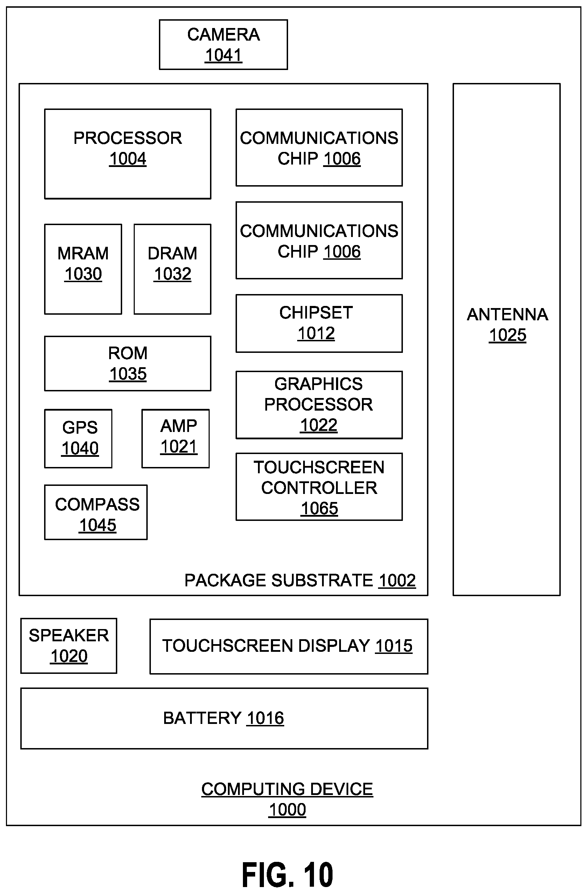

**FIG. 10** is a functional block diagram of an electronic computing device 1000, in accordance with an embodiment of the present invention. The computing device may be found inside mobile computing platform 905 or server machine 906, as described elsewhere herein. Device 1000 further includes a package substrate 1002 hosting a number of components, such as, but not limited to, a processor 1004 (e.g., an applications processor). Processor 1004 may be physically and/or electrically coupled to package substrate 1002. In general, the term "processor" or "microprocessor" may refer to any device or portion of a device that processes electronic data from registers and/or memory to transform that electronic data into other electronic data that may be further stored in registers and/or memory. In some examples, one or more of the components of computing device 1000 includes an IC package 950 with a substrate having a glass core with a large footprint, one or more thin redistribution layers, and one or more electrical components, as described elsewhere herein. In some examples, package substrate 1002 comprises glass core substrate with coupled inductor structures integrated into the substrate, as described elsewhere herein.

In various examples, one or more communication chips 1006 may also be physically and/or electrically coupled to the package substrate 1002. In further implementations, communication chips 1006 may be part of processor 1004. Depending on its applications, computing device 1000 may include other components that may or may not be physically and electrically coupled to package substrate 1002. These other components include, but are not limited to, volatile memory (e.g., DRAM 1032), non-volatile memory (e.g., ROM 1035), flash memory (e.g., NAND or NOR), magnetic memory (MRAM 1030), a graphics processor 1022, a digital signal processor, a crypto processor, a chipset 1012, an antenna 1025, touchscreen display 1015, touchscreen controller 1065, battery 1016, audio codec, video codec, power amplifier 1021, global positioning system (GPS) device 1040, compass 1045, accelerometer, gyroscope, speaker 1020, camera 1041, and mass storage device (such as hard disk drive, solid-state drive (SSD), compact disk (CD), digital versatile disk (DVD), and so forth), or the like..

Communication chips 1006 may enable wireless communications for the transfer of data to and from the computing device 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chip 1006 may implement any of a number of wireless standards or protocols. As discussed, computing device 1000 may include a plurality of communication chips 1006. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the scope of the present disclosure.

It will be recognized that the invention is not limited to the embodiments so described, but can be practiced with modification and alteration without departing from the scope of the appended claims. For example, the above embodiments may include specific combinations of features as further provided below.

Example 1: An apparatus comprising: an integrated circuit (IC) die over a substrate, the substrate comprising a glass core, the glass core comprising a first surface and a second surface opposite the first surface, wherein the first surface comprises an area of at least 5,000 mm²; an electrical component within a region of the glass core between the first and second surfaces; and a redistribution layer on the first surface, wherein the redistribution layer comprises a thickness of 100 µm or less.

Example 2: The apparatus of example 1, wherein the redistribution layer is a first redistribution layer, further comprising a second redistribution layer on the second surface, the second redistribution layer comprising a thickness of 100 µm or less.

Example 3: The apparatus of example 1 or example 2, further comprising a through-glass via (TGV) extending between the first and second surfaces, wherein the TGV contacts a first metal feature in the first redistribution layer and a second metal feature in the second redistribution layer.

Example 4: The apparatus of any of examples 1 through 3, wherein the IC die is a first IC die, further comprising a second IC die over and directly bonded to the first IC die.

Example 5: The apparatus of example 4, wherein the second IC die comprises memory circuitry or logic circuitry.

Example 6: The apparatus of any of examples 1 through 5, wherein the electrical component comprises a capacitor or an inductor.

Example 7: The apparatus of any of examples 1 through 3, wherein the IC die is a first IC die and the electrical component comprises a second IC die.

Example 8: The apparatus of example 7, or any of examples 1 through 3, wherein the second IC die comprises voltage regulation circuitry or bridge circuitry.

Example 9: The apparatus of example 1, or any of examples 4 through 8, wherein the redistribution layer comprises interconnect lines having a pitch of 5 µm or less.

Example 10: The apparatus of any of examples 4 through 9, wherein the IC die is directly bonded to the substrate.

Example 11: The apparatus of any of examples 4 through 10, wherein a thickness of the glass core is between 0.2 mm and 1.6 mm.

Example 12: An apparatus comprising: a substrate comprising a glass core, the glass core comprising a first surface and a second surface opposite the first surface; an electrical component within a region of the glass core between the first and second surfaces; a first redistribution layer on the first surface, and a second redistribution layer on the second surface, the first redistribution layer comprising a plurality of first metallization layers, the second redistribution layer comprising a plurality of second metallization layers, wherein each of the first and second metallization layers comprises a thickness in a range of 0.1 µm to 10 µm; and a through-glass via extending between the first and second surfaces, wherein the through-glass via contacts a first metal feature in the first redistribution layer and a second metal feature in the second redistribution layer.

Example 13: The apparatus of example 12, wherein the substrate comprises a footprint of at least 5,000 mm².

Example 14: The apparatus of example 12 or example 13, wherein the plurality of first metallization layers is less than 12 layers.

Example 15: The apparatus of any of examples 12 through 14, further comprising an integrated circuit (IC) die bonded to metal features between a first side of the IC die and the first redistribution layer.

Example 16: The apparatus of any of examples 12 through 15, wherein the IC die is a first IC die and the first IC die comprises a second side opposite the first side, further comprising a second IC die directly bonded to metal features on the second side of the first IC die.

Example 17: The apparatus of any of examples 12 through 16, wherein the electrical component comprises a capacitor, an inductor, or an integrated circuit (IC) die.

Example 18: A system, comprising: a substrate comprising a glass layer, the glass layer comprising a first surface and a second surface opposite the first surface; a first redistribution layer (RDL) adjacent to the first surface, and a second RDL adjacent to the second surface, wherein the first RDL comprises a thickness of 100 µm or less; at least one through-glass via extending between the first and second RDL; an integrated circuit (IC) die bonded to metal features over the first RDL; and a power supply coupled to the substrate to power the IC die.

Example 19: The system of example 18, wherein the first surface comprises an area of at least 5,000 mm².

Example 20: The system of example 18 or example 19, further comprising an electrical component within a region of the glass core between the first and second surfaces.

## Claims

1. An apparatus comprising:
an integrated circuit, IC, die over a substrate, the substrate comprising a glass core, the glass core comprising a first surface and a second surface opposite the first surface, wherein the first surface comprises an area of at least 5,000 mm²;
an electrical component within a region of the glass core between the first and second surfaces; and
a redistribution layer on the first surface, wherein the redistribution layer comprises a thickness of 100 µm or less.

2. The apparatus of claim 1, wherein the redistribution layer is a first redistribution layer, further comprising a second redistribution layer on the second surface, the second redistribution layer comprising a thickness of 100 µm or less.

3. The apparatus of claim 1 or claim 2, further comprising a through-glass via, TGV, extending between the first and second surfaces, wherein the TGV contacts a first metal feature in the first redistribution layer and a second metal feature in the second redistribution layer.

4. The apparatus of any of claims 1 through 3, wherein the IC die is a first IC die, further comprising a second IC die over and directly bonded to the first IC die.

5. The apparatus of claim 4, wherein the second IC die comprises memory circuitry or logic circuitry.

6. The apparatus of any of claims 1 through 5, wherein the electrical component comprises a capacitor or an inductor.

7. The apparatus of any of claims 1 through 5, wherein the electrical component comprises an inductor comprising a magnetic material surrounding a feature extending between the first surface and the second surface, the feature comprising an outer wall comprising a conductive material and an inner core comprising an insulating material.

8. The apparatus of any of claims 1 through 3, wherein the IC die is a first IC die and the electrical component comprises a second IC die.

9. The apparatus of claim 8, wherein the second IC die comprises voltage regulation circuitry or bridge circuitry.

10. The apparatus of any of claims 2 through 9, wherein the first redistribution layer comprises interconnect lines having a pitch of 5 µm or less.

11. The apparatus of any of claims 1 through 3, wherein the IC die is directly bonded to the substrate.

12. The apparatus of any of claims 2 through 11, wherein a thickness of the glass core is between 0.2 mm and 1.6 mm.

13. The apparatus of any of claims 2 through 12, wherein the first redistribution layer comprises a plurality of first metallization layers, the second redistribution layer comprises a plurality of second metallization layers, and each of the first and second metallization layers comprise a thickness in a range of 0.1 µm to 10 µm.

14. The apparatus of claim 13, wherein the plurality of first metallization layers is less than 12 layers.

15. The apparatus of any of claims 1 through 14, further comprising a power supply coupled to the substrate to power the IC die.
